# FASCICULE DE BREVET EUROPEEN

(11) **EP 3 037 897 B1**
(45) Date de publication et mention de la délivrance du brevet: **29.04.2020**
(21) Numéro de dépôt: 14200000.9
(22) Date de dépôt: 23.12.2014
(51) Int. Cl.: G04B 19/12

(54) **PROCÉDÉ DE FABRICATION D'UN CADRAN D'AFFICHAGE POUR OBJET PORTABLE TEL QU'UNE PIÈCE D'HORLOGERIE ET CADRAN D'AFFICHAGE**
HERSTELLUNGSVERFAHREN EINES ZIFFERBLATTS FÜR TRAGBAREN GERÄT WIE EINE UHR, UND ZIFFERBLATT
METHOD OF MANUFACTURING A DISPLAY DIAL FOR A PORTABLE OBJECTSUCH AS A TIMEPIECE AND DISPLAY DIAL

(43) Date de publication de la demande: 29.06.2016
(73) Titulaire: The Swatch Group Research and Development Ltd., 2074 Marin (CH)
(72) Inventeur: SAGARDOYBURU, Michel, 2000 Neuchâtel (CH)
(74) Mandataire: Supper, Marc

(56) Documents cités:
- EP-A1- 2 578 372
- EP-A1- 2 579 106
- EP-A1- 2 579 108
- JP-A- H0 275 991
- JP-A- S58 219 475

## Description

### Domaine de l'invention

La présente invention concerne un cadran d'affichage pour un objet portable tel qu'une pièce d'horlogerie. Plus précisément, la présente invention concerne un cadran d'affichage pour une montre-bracelet, un dispositif d'affichage numérique étant disposé sous le cadran. La présente invention concerne également un procédé de fabrication d'un tel cadran d'affichage.

### Arrière-plan technologique de l'invention

Soit un cadran pour un objet portable tel qu'une pièce d'horlogerie réalisé par exemple en un matériau plastique transparent. Une couche semi-transparente est par exemple imprimée sur une surface supérieure du cadran dirigée du côté d'un utilisateur afin de masquer au regard de l'utilisateur les composants tels qu'une cellule solaire disposés sous la surface du cadran. Une fraction de la surface supérieure du cadran est laissée vierge de toute impression afin de ménager une fenêtre transparente. Un dispositif d'affichage numérique tel qu'une cellule d'affichage à cristal liquide est collé sous la surface du cadran, à l'aplomb de la fenêtre, afin que les informations affichées par le dispositif d'affichage à cristal liquide puissent être lues par l'utilisateur.

L'inconvénient d'un tel type de cadran est qu'il n'est pas possible de lui conférer un fini particulier à l'aide des moyens de finissage mécaniques conventionnels. En effet, imaginons par exemple que l'on veuille brosser le cadran au moyen d'une brosse métallique afin de former dans le cadran de fines raies qui vont rayonner à partir du centre du cadran. Ces fines raies, par des phénomènes de réflexion de la lumière, vont donner au cadran un aspect chatoyant et changeant. Malheureusement, on comprend que dans le cas d'un cadran dont une partie doit rester transparente, il n'est pas possible d'effectuer un tel brossage mécanique. En effet, il est impossible d'interrompre le brossage lorsque la brosse passe au voisinage de la fenêtre transparente afin d'éviter que la brosse ne raye la fenêtre, ce qui rendrait les informations affichées par le dispositif d'affichage numérique illisibles. On comprend donc bien que dans le cas d'un cadran réalisé en un matériau transparent dont une partie doit demeurer transparente, il n'est pas possible d'appliquer à un tel cadran des opérations de finissage mécaniques, ce qui limite considérablement l'aspect final que l'on peut donner à un tel cadran.

D'autre part, le dispositif d'affichage numérique étant collé directement sous la surface du cadran, à l'aplomb de la fenêtre transparente, il est également nécessaire de munir cette fenêtre d'une couche antireflet afin de garantir une bonne lisibilité des informations affichées par le dispositif d'affichage numérique.

Dans le domaine de l'horlogerie, on connaît aussi les documents JPH02-75991 et JP-S58-219475. Ces documents décrivent la réalisation de cadrans dont un décor de surface est réalisé par impression à froid assistée par rayonnement ultraviolet.

### Résumé de l'invention

La présente invention a pour but de remédier aux inconvénients mentionnés ci-dessus ainsi qu'à d'autres encore en procurant un procédé de fabrication d'un cadran d'affichage transparent pour un objet portable dans lequel il est notamment possible de conférer au cadran d'affichage transparent un fini donné tout en conservant les propriétés de transparence d'au moins une zone du cadran d'affichage transparent.

A cet effet, la présente invention concerne deux procédés alternatifs de fabrication d'un cadran, ces procédés étant définis par les revendications indépendantes 1 et 2.

Grâce à ces caractéristiques, la présente invention procure un procédé de fabrication d'un cadran d'affichage transparent pour un objet portable comme une montre-bracelet qui, en une unique étape de fabrication, permet de structurer sur au moins une partie de la surface du cadran un décor, tandis qu'une autre partie de la surface du cadran qui est destinée à former une fenêtre permettant la visualisation d'un dispositif d'affichage digital placé sous le cadran, à l'aplomb de la fenêtre, reçoit un filtre antireflet.

Grâce à l'invention, il est donc possible, pour la première fois à la connaissance de la Demanderesse, de mettre à la disposition du marché des cadrans d'affichage transparents dont au moins une zone est conservée transparente afin de délimiter une fenêtre permettant de visualiser un dispositif disposé sous le cadran, tandis qu'au moins une autre fraction de la surface du cadran est revêtue d'un décor en relief.

En outre, grâce au procédé selon l'invention, on jouit d'une totale liberté quant au type de décor qu'il est possible d'appliquer sur le cadran d'affichage transparent.

Il faut également noter que le procédé selon l'invention est mis en œuvre à température ambiante, avec une grande vitesse de duplication et un alignement précis.

Enfin, du fait que l'impression simultanée du décor en relief et du filtre antireflet se fait à température ambiante, on a affaire à un procédé économique qui ne nécessite pas de chauffer les cadrans, rapide car il n'est pas non plus nécessaire d'attendre que les cadrans refroidissent après impression et qui, surtout, n'induit aucune limitation quant au choix du matériau dans lequel est réalisé le cadran d'affichage transparent.

De plus, comme défini dans la revendication indépendante 3, l'invention concerne également un cadran d'affichage transparent pour un objet portable, ce cadran d'affichage transparent comprenant sur une première partie au moins de sa surface un décor réalisé par impression à froid (c'est-à-dire à température ambiante) assistée par rayonnement ultraviolet, technique également connue sous la dénomination « impression assistée par UV » ou « nano-impression assistée par UV » selon la taille des motifs que l'on veut imprimer, une seconde partie de la surface du cadran d'affichage transparent comprenant un filtre antireflet réalisé par impression à froid assistée par rayonnement ultraviolet afin de délimiter une fenêtre de visualisation.

Enfin, en ce qui concerne le filtre antireflet, le cadran d'affichage transparent constitue le substrat de ce filtre. Il n'est donc pas nécessaire de structurer le filtre antireflet sur un substrat, puis de coller l'ensemble ainsi obtenu sur le cadran, ce qui permet de réduire l'épaisseur du cadran résultant.

### Brève description des figures

D'autres caractéristiques et avantages de la présente invention ressortiront plus clairement de la description détaillée qui suit d'un mode de mise en œuvre du procédé selon l'invention, cet exemple étant donné à titre purement illustratif et non limitatif seulement, en liaison avec le dessin annexé sur lequel :
- la figure 1 est une vue en plan d'une montre-bracelet équipée d'un cadran d'affichage transparent conforme à l'invention ;
- la figure 2 est une vue en coupe du cadran d'affichage transparent de la figure 1 selon un axe midi-6 heures ;
- les figures 3A à 3D illustrent un procédé de fabrication du cadran d'affichage transparent de la figure 1 par impression à froid assistée par rayonnement ultraviolet, et
- les figures 4A à 4D illustrent une variante du procédé de fabrication du cadran d'affichage transparent de la figure 1.

### Description détaillée d'un mode de réalisation de l'invention

La présente invention procède de l'idée générale inventive qui consiste à revêtir simultanément par impression à froid assistée par rayonnement ultraviolet un cadran d'affichage transparent pour un objet portable comme une montre-bracelet d'une part d'un motif décoratif sur une partie au moins de sa surface, et d'autre part d'un filtre antireflet sur une autre partie de la surface du cadran. A la connaissance de la Demanderesse, il n'existe pas sur le marché de cadran réalisé en un matériau transparent tel que du plastique, du verre ou du saphir et dont une zone transparente est revêtue d'un filtre antireflet en relief afin de délimiter une fenêtre pour permettre la visualisation d'un dispositif disposé sous cette zone transparente, tandis qu'une partie au moins de la surface restante du cadran transparent est revêtue d'un décor en relief qui imite les décors en relief dont peuvent être revêtus les cadrans métalliques conventionnels comme le guillochage ou les cottes de Genève. Ce résultat remarquable est atteint grâce à l'utilisation d'un procédé d'impression à froid assistée par rayonnement ultraviolet. Un tel procédé fait appel à un moule qui présente simultanément un premier motif en relief correspondant au décor à imprimer et un second motif en relief correspondant au filtre antireflet à imprimer. Après dépôt sur la surface du cadran d'affichage transparent située du côté de l'utilisateur d'une couche d'un mélange d'un monomère et d'un agent de réticulation sensible au rayonnement ultraviolet, on applique le moule sur cette couche afin de transférer dans la couche les premier et second motifs en relief portés par le moule. La couche de mélange de monomère et d'agent de réticulation est ensuite solidifiée par insolation ultraviolette à travers le moule, puis le moule est retiré.

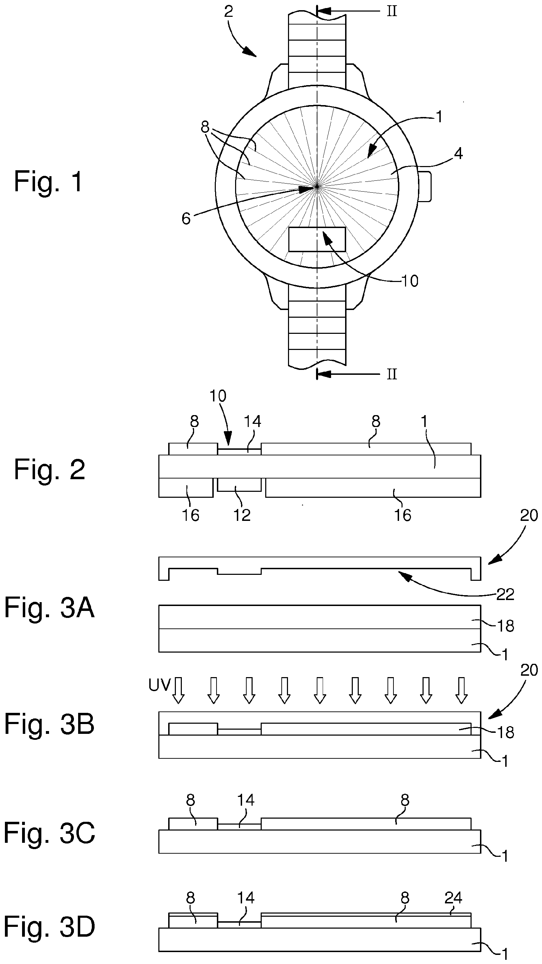

La figure 1 est une vue en plan d'un cadran d'affichage transparent conforme à l'invention. Désigné dans son ensemble par la référence numérique générale 1, ce cadran d'affichage transparent est destiné à équiper un objet portable tel qu'une montre-bracelet 2. Le cadran d'affichage transparent 1 comprend sur une première partie au moins de sa surface 4 un décor en relief 6 réalisé par impression à froid assistée par rayonnement ultraviolet. Dans l'exemple représenté, le décor en relief 6 est formé de fines stries 8 qui rayonnent à partir du centre du cadran d'affichage transparent 1. Le cadran d'affichage transparent 1 comporte également une fenêtre transparente 10 permettant à l'utilisateur de voir un dispositif tel qu'une cellule d'affichage à cristal liquide 12 placée sous la fenêtre de visualisation transparente 10 (voir figure 2). Pour permettre à l'utilisateur une lecture facile des informations affichées par la cellule d'affichage à cristal liquide 12, la fenêtre transparente 10 est revêtue d'un filtre antireflet 14. Comme expliqué ci-dessous en détail en liaison avec les figures 3A à 3D, ce filtre antireflet 14 est structuré en même temps que le décor en relief 6 grâce à un procédé d'impression à froid assisté par rayonnement ultraviolet. L'effet antireflet du filtre antireflet 14 est typiquement assuré par des structures nanométriques, par exemple du type « motheye », grâce auxquelles la lumière tombant sur la fenêtre transparente 10 ne perçoit pas un changement abrupt de l'indice de réfraction mais plutôt un changement graduel. En effet, les structures nanométriques, en raison de leurs dimensions, sont perçues par la lumière comme formant un indice de réfraction moyen car la longueur d'onde de la lumière incidente est supérieure à la périodicité des structures nanométriques. Enfin, on peut par exemple prévoir de disposer sous le cadran d'affichage transparent 1 une cellule solaire 16 destinée, non limitativement, à recharger un accumulateur logé dans la boîte de montre.

Les diverses étapes du procédé de fabrication d'un cadran d'affichage transparent selon l'invention vont maintenant être examinées en liaison avec les figures 3A à 3D.

A la figure 3A, une couche de mélange 18 d'un monomère et d'un agent de réticulation sensible au rayonnement ultraviolet est déposée sur le cadran d'affichage transparent 1. Par ailleurs, on positionne au-dessus du cadran d'affichage transparent 1 un moule d'impression 20. Ce moule d'impression 20 est réalisé en un matériau élastomère transparent au rayonnement ultraviolet tel que du polydiméthylsiloxane ou PDMS. Ce moule d'impression 20 porte une empreinte 22 qui correspond à l'image en négatif du décor en relief 6 et du filtre antireflet 14 que l'on cherche à imprimer à la surface du cadran d'affichage transparent 1. Ce moule d'impression 20 peut être un moule maître, c'est-à-dire un moule original. Un tel moule maître est cependant coûteux à réaliser. Il est également fragile, de sorte que si on l'utilise de manière répétée, il risque de s'user rapidement. C'est pourquoi l'on préfère travailler avec des moules d'impression 20 qui sont des copies du moule maître. On comprend que si l'empreinte du moule maître correspond à l'image en positif du décor en relief 6 et du filtre antireflet 14 que l'on cherche à imprimer, l'empreinte du moule d'impression 20 obtenue par copie du moule maître correspondra au négatif de l'image que l'on cherche à obtenir.

A la figure 3B, on presse l'empreinte 22 du moule d'impression 20 sur la couche de mélange 18 avec une légère pression et le mélange est solidifié à température ambiante par photopolymérisation sous irradiation ultraviolette à travers le moule d'impression 20.

A la figure 3C, après l'insolation, le décor en relief 6 et le filtre antireflet 14 sont imprimés dans la couche de mélange 18 et le moule d'impression 20 se détache facilement de la couche de mélange 18 solidifiée.

On comprendra que dans la mesure où l'empreinte du moule d'impression 20 que l'on presse sur la couche de mélange 18 correspond au négatif de l'image que l'on cherche à obtenir, le décor en relief 6 et le filtre antireflet 14 sont imprimés en positif dans cette couche de mélange 18.

Enfin, à la figure 3D, les stries 8 qui forment le décor en relief 6 sont recouvertes d'une couche mince semi-transparente 24, par exemple métallique, qui laisse passer la lumière vers la cellule solaire mais qui masque cette dernière au regard de l'utilisateur.

Il va de soi que la présente invention n'est pas limitée au mode de réalisation qui vient d'être décrit et que diverses modifications et variantes simples peuvent être envisagées par l'homme du métier sans sortir du cadre de l'invention tel que défini par les revendications annexées. En particulier, on comprendra qu'au sens de la présente invention, on entend par décor aussi bien un motif décoratif qu'un motif fonctionnel tel qu'une inscription, un chiffre ou bien encore une graduation de tour d'heure.

On comprendra également qu'au sens de la présente invention, il suffit que le cadran d'affichage soit transparent et qu'une fenêtre transparente recouverte d'un film antireflet soit ménagée dans ce cadran et qu'au moins une partie de la surface restante du cadran d'affichage transparent soit recouverte d'un motif décoratif en relief. Ce qui est placé sous la surface du cadran est sans importance pour l'invention. Il peut s'agir d'une cellule solaire, d'un dispositif d'affichage d'information, d'un mouvement d'horlogerie ou autre.

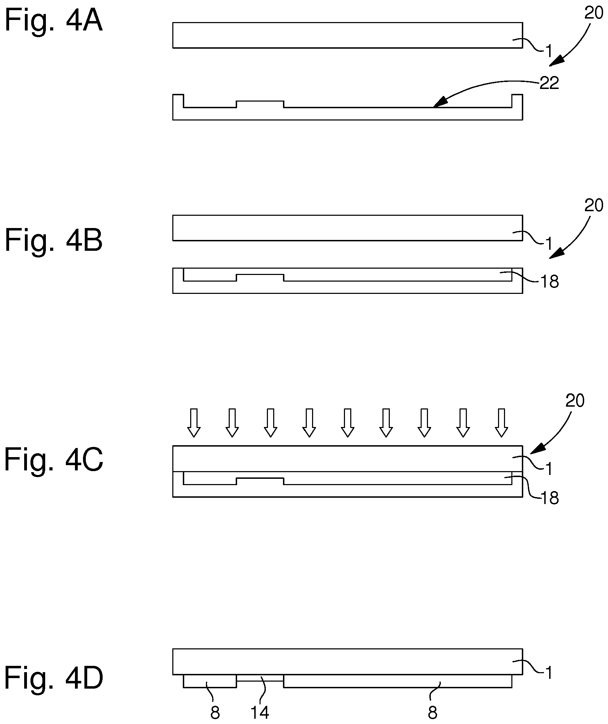

Selon une autre variante de l'invention (voir figures 4A à 4D), l'empreinte 22 du moule d'impression 20 obtenue par copie du moule maître correspond au négatif de l'image que l'on cherche à obtenir. Le moule d'impression 20 est ensuite placé à l'envers, puis l'on dépose sur l'empreinte 22 du moule d'impression 20 une couche de mélange 18 d'un monomère et d'un agent de réticulation sensible au rayonnement ultraviolet. On positionne ensuite le cadran d'affichage 1 au-dessus du moule d'impression 20, du côté de l'empreinte 22. Finalement, on insole à froid (autrement dit à température ambiante) la couche de mélange 18 de monomère et d'agent de réticulation au moyen d'un rayonnement ultraviolet à travers le cadran d'affichage transparent 1. Lorsque la couche de mélange 18 est polymérisée, on retire le moule d'impression 20.

### Nomenclature

Cadran d'affichage transparent 1
Montre-bracelet 2
Surface 4
Décor en relief 6
Fines raies 8
Fenêtre transparente 10
Cellule d'affichage à cristal liquide 12
Filtre antireflet 14
Cellule solaire 16
Couche de mélange 18
Moule d'impression 20
Empreinte 22
Couche mince semi-transparente 24

## Revendications

1. Procédé de fabrication d'un cadran d'affichage transparent (1) pour un objet portable, ce procédé comprenant les étapes suivantes :
- réaliser un moule (20) portant une empreinte (22) formée d'un premier motif en relief pour imprimer un décor (6) sur au moins une première partie de la surface (4) du cadran d'affichage transparent (1), et d'un second motif en relief pour imprimer un filtre antireflet (14) sur une seconde partie de la surface (4) du cadran d'affichage transparent (1) ;
- déposer sur le cadran une couche (18) d'un mélange d'un monomère et d'un agent de réticulation sensible au rayonnement ultraviolet ;
- appliquer l'empreinte (22) du moule (20) sur la couche de mélange (18) de monomère et d'agent de réticulation ;
- solidifier la couche de mélange (18) de monomère et d'agent de réticulation par photopolymérisation sous une irradiation ultraviolette à travers le moule (20), et
- après insolation, retirer le moule (20).

2. Procédé de fabrication d'un cadran d'affichage transparent (1) pour un objet portable, ce procédé comprenant les étapes suivantes :
- réaliser un moule (20) portant une empreinte (22) formée d'un premier motif en relief pour imprimer un décor (6) sur au moins une première partie de la surface (4) du cadran d'affichage transparent (1), et d'un second motif en relief pour imprimer un filtre antireflet (14) sur une seconde partie de la surface (4) du cadran d'affichage transparent (1) ;
- placer le moule d'impression (20) à l'envers, puis déposer sur l'empreinte (22) du moule d'impression (20) une couche de mélange (18) d'un monomère et d'un agent de réticulation sensible au rayonnement ultraviolet ;
- positionner le cadran d'affichage transparent (1) sur le moule d'impression (20), du côté de l'empreinte (22).
- solidifier la couche de mélange (18) de monomère et d'agent de réticulation par photopolymérisation sous une irradiation ultraviolette à travers le cadran d'affichage transparent (1), et
- après insolation, retirer le moule (20).

3. Cadran d'affichage transparent pour un objet portable, ce cadran d'affichage transparent (1) comprenant sur une première partie au moins de sa surface (4) un décor (6) réalisé par impression à froid assistée par rayonnement ultraviolet, une seconde partie de la surface (4) du cadran d'affichage transparent (1) comprenant un filtre antireflet (14) également réalisé par impression à froid assistée par rayonnement ultraviolet afin de délimiter une fenêtre transparente (10).

## Patentansprüche

1. Verfahren zur Herstellung eines transparenten Anzeigezifferblatts (1) für ein tragbares Objekt, wobei das Verfahren die folgenden Schritte umfasst:
- Herstellen einer Form (20), die einen Abdruck (22) trägt, gebildet aus einem ersten Reliefmuster zum Aufprägen eines Dekors (6) auf mindestens einen ersten Abschnitt der Oberfläche (4) des transparenten Anzeigezifferblatts (1) und einem zweiten Reliefmuster zum Aufprägen einer Antireflexschicht (14) auf einen zweiten Abschnitt der Oberfläche (4) des transparenten Anzeigezifferblatts (1);
- Abscheiden einer Schicht (18) aus einem Gemisch aus einem Monomer und einem für ultraviolette Strahlung empfindlichen Vernetzungsmittel auf dem Zifferblatt;
- Aufbringen des Abdrucks (22) der Form (20) auf die Schicht (18) aus dem Monomer- und Vernetzungsmittelgemisch;
- Verfestigen der Schicht (18) aus dem Monomer- und Vernetzungsmittelgemisch durch Photopolymerisation bei ultravioletter Bestrahlung durch die Form (20), sowie
- Entfernen der Form (20) nach einer Insolation.

2. Verfahren zur Herstellung eines transparenten Anzeigezifferblatts (1) für ein tragbares Objekt, wobei das Verfahren folgende Schritte umfasst:
- Herstellen einer Form (20), die einen Abdruck (22) bildet eines ersten Reliefmusters zum Aufprägen eines Dekors (6) auf mindestens einen ersten Abschnitt der Oberfläche (4) des transparenten Anzeigezifferblatts (1) und eines zweiten Reliefmusters zum Aufprägen einer Antireflexschicht (14) auf einen zweiten Abschnitt der Oberfläche (4) des transparenten Anzeigezifferblatts (1);
- Drehen der Abdruckform (20) auf den Kopf sowie anschließend Legen einer Schicht (18) aus einem Gemisch aus einem Monomer und einem für ultraviolette Strahlung empfindlichen Vernetzungsmittel auf den Abdruck (22) der Abdruckform (20);
- Positionieren des transparenten Anzeigezifferblatts (1) auf der Abdruckform (20) auf der Seite des Abdrucks (22);
- Verfestigen der Schicht (18) aus einem Monomer- und Vernetzungsmittelgemisch durch Fotopolymerisation bei ultravioletter Bestrahlung durch das transparente Anzeigezifferblatt (1), und
- Entfernen der Form (20) nach der Insolation.

3. Transparentes Anzeigezifferblatt für ein tragbares Objekt, wobei dieses transparente Anzeigezifferblatt (1) auf mindestens einem ersten Abschnitt seiner Oberfläche (4) ein Dekor (6) aufweist, das durch UV-unterstützten Kaltdruck hergestellt wird, wobei ein zweiter Abschnitt der Oberfläche (4) des transparenten Anzeigezifferblatts (1) eine Antireflexschicht (14) aufweist, die ebenfalls durch UV-unterstützten Kaltdruck hergestellt wird, um ein transparentes Fenster (10) zu begrenzen.

## Claims

1. Method for fabricating a transparent display dial (1) for a portable object, the method comprising the steps of:
- creating a mould (20) bearing a footprint (22) formed of a first 3D pattern for imprinting a decoration (6) on at least a first portion of the surface (4) of the transparent display dial (1), and of a second 3D pattern for imprinting an antireflective filter (14) on a second portion of the surface (4) of the transparent display dial (1);
- depositing on the dial a mixed layer (18) of a monomer and a cross-linking agent sensitive to ultraviolet radiation;
- applying the footprint (22) of the mould (20) on the mixed monomer and cross-linking agent layer (18);
- solidifying the mixed monomer and cross-linking agent layer (18) by photopolymerization under ultraviolet irradiation through the mould (20), and
- after insolation, removing the mould (20).

2. Method for fabricating a transparent display dial (1) for a portable object, the method comprising the steps of:
- creating a mould (20) bearing a footprint (22) formed of a first 3D pattern for imprinting a decoration (6) on at least a first portion of the surface (4) of the transparent display dial (1), and of a second 3D pattern for imprinting an antireflective filter (14) on a second portion of the surface (4) of the transparent display dial (1);
- placing the printing mould (20) upside down, and then depositing on the footprint (22) of the printing mould (20) a mixed layer (18) of a monomer and a cross-linking agent sensitive to ultraviolet radiation;
- positioning the transparent display dial (1) on the printing mould (20), on the side of the footprint (22);
- solidifying the mixed monomer and cross-linking agent layer (18) by photopolymerization under ultraviolet irradiation through the transparent display dial (1), and
- after insolation, removing the mould (20).

3. Transparent display dial for a portable object, said transparent display dial (1) including on a first portion at least of the surface thereof (4) a decoration (6) created by cold ultraviolet-assisted imprinting, a second portion of the surface (4) of the transparent display dial (1) including an antireflective filter (14) also created by cold ultraviolet-assisted imprinting so as to delimit a transparent aperture (10).
